# FASCICULE DE BREVET EUROPEEN

(11) **EP 1 528 846 B1**
(45) Date de publication et mention de la délivrance du brevet: **23.12.2009**
(21) Numéro de dépôt: 04292256.7
(22) Date de dépôt: 20.09.2004
(51) Int. Cl.: H05G 2/00

(54) **Source EUV**
EUV-Quelle
EUV source

(30) Priorité: 26.09.2003 FR 0311280
(43) Date de publication de la demande: 04.05.2005
(73) Titulaire: Alcatel Lucent, 75008 Paris (FR)
(72) Inventeur: Barthod, Benoit, 74730 Naves-Parmelan (FR); Rival, Jean-Luc, 74370 Villaz (FR); Morpain, Matthieu, 25115 Pouilley les Vignes (FR)
(74) Mandataire: Korakis-Ménager, Sophie

(56) Documents cités:
- EP-A- 0 858 249
- EP-A- 1 047 288
- US-B1- 6 304 630
- OESTREICH S. ET AL.: 'Multilayer reflectance during exposure to EUV radiation' PROCEEDINGS OF THE SPIE vol. 4646, pages 61 - 71, XP001059823
- FIEDOROWICZ H. ET AL.: 'Strong extreme ultraviolet emission from a double-stream xenon/helium gas puff target irradiated with a Nd:YAG laser' OPTICS COMMUNICATIONS vol. 184, 2000, pages 161 - 167, XP000421841

## Description

La présente invention concerne les techniques de photolithographie mises en oeuvre pour la fabrication de composants à semi-conducteur, et concerne plus particulièrement les moyens pour produire une radiation EUV (Extrême UltraViolet) utilisée dans la production de composants de microélectronique à semi-conducteur, ayant des géométries inférieures ou égales à 70 nm.

Lors de la fabrication de composants de microélectronique, par exemple de puces de mémoire dynamique, on traite des plaquettes de semi-conducteur dans des chambres de procédés contenant une atmosphère gazeuse à faible pression.

Certaines étapes des procédés consistent à utiliser une technique de photolithographie, dans laquelle une radiation lumineuse est utilisée pour traiter ou durcir une couche superficielle de matériau photosensible recouvrant la plaquette de semi-conducteur, couche qui empêche ensuite l'attaque chimique de certaines zones des plaquettes de semi-conducteur.

On cherche à réaliser des circuits intégrés ayant des densités de plus en plus hautes, et il est donc nécessaire de réaliser des masques ayant des reliefs ou des zones différenciées ayant des tailles de plus en plus petites. De cette façon, on réalise des éléments unitaires tels que les transistors et les diodes ayant des dimensions de plus en plus petites, qui peuvent donc être intégrés en plus grand nombre sur une surface donnée de plaquette de semi-conducteur. Or la taille des éléments unitaires et des détails qu'il est possible de réaliser par photolithographie sur une plaquette de semi-conducteur dépend de la longueur d'onde de la radiation utilisée. Il est ainsi nécessaire d'émettre une radiation dont la longueur d'onde est de plus en plus petite.

On tend actuellement à utiliser une radiation de l'ordre de 13,5 nm, que l'on appelle radiation EUV. La bande de radiation EUV est en général de 5 à 20 nm.

Par ailleurs, le temps de traitement par photolithographie, pour traiter ou durcir une couche photosensible, est directement proportionnel à l'intensité de la radiation reçue par la couche durant le procédé de photolithographie. Pour réduire les temps de traitement, et augmenter ainsi les cadences de production de composants de microélectronique, il est ainsi avantageux de disposer d'une source de radiation la plus intense possible, et également d'assurer la transmission la plus efficace possible de cette radiation entre la source et la couche à traiter.

Pour cela, on a déjà proposé, dans le document US 6,133,577 A, de réaliser une source de radiation EUV à forte puissance, comprenant des moyens pour injecter, à l'entrée d'une zone d'irradiation, un flux de matériau générateur de radiation, à savoir un gaz noble tel que l'argon, l'hélium ou le xénon, à vitesse supersonique. Des moyens de diffuseur permettent de recueillir le flux de matériau générateur de radiation en sortie de la zone d'irradiation. Des moyens permettent de générer et focaliser un ou plusieurs faisceaux d'énergie sur le matériau générateur de radiation dans la zone d'irradiation, produisant ainsi une radiation EUV émise par le matériau générateur de radiation dans la zone d'irradiation. On recueille cette radiation EUV en la focalisant par des moyens optiques. Tous les éléments, tels que les moyens pour injecter le flux de gaz générateur de radiation, les moyens pour recueillir le flux de gaz générateur de radiation, et les moyens pour recueillir et focaliser la radiation EUV émise, sont contenus dans une chambre unique maintenue à une pression d'environ 1,3 millibars (130 Pascals).

Il apparaît qu'un tel dispositif n'est pas applicable dans les procédés de photolithographie pour production de composants de microélectronique, car la radiation EUV reçue par les couches à traiter est nettement insuffisante.

On connaît par ailleurs, du document US 6,576,912 B, un appareil de photolithographie par radiation EUV dans lequel la source de radiation peut être une source de plasma par laser, une source de plasma par décharge, une source de radiation par synchrotron. Le document enseigne que ces sources de radiation peuvent nécessiter une pression de l'ordre de 0,1 millibar.

Ainsi, le document donne un exemple de plasma de décharge à partir de xénon qui émet des radiations notamment dans la plage d'environ 13,5 nm. Le plasma est généré dans une enceinte où règne une pression typique de 0,1 millibar. A une telle pression, la radiation EUV est rapidement absorbée : il reste seulement 0,3 % de la radiation après un trajet de 1 mètre.

Pour éviter l'absorption de la radiation par le gaz environnant, le document préconise de limiter le trajet de la radiation dans la zone de haute pression, en confinant la zone d'émission lumineuse dans une première chambre à vide séparée d'une seconde chambre à vide par une paroi munie d'un dispositif de transmission de radiation qui est transparent à la radiation EUV tout en s'opposant au passage des gaz, la seconde chambre étant maintenue à une pression 100 fois plus faible par une pompe turbomoléculaire ayant une vitesse de pompage effective de 6 000 litres / seconde.

Le dispositif de transmission de radiation dans la paroi intermédiaire est constitué d'une structure à multiplicité de canaux étroits adjacents séparés par des parois qui sont sensiblement parallèles à la direction de propagation de la radiation. Les canaux ont un diamètre de 0,2 à 0,7 mm et une longueur de 5 à 50 mm.

Une première difficulté réside dans le fait que les sources de radiation EUV mentionnées dans ce document délivrent une puissance EUV qui n'est pas suffisante pour les besoins actuels de l'industrie des semi-conducteurs.

Une seconde difficulté réside dans la relative complexité du dispositif de transmission de radiation à canaux étroits adjacents, et dans le fait que ces canaux de petite taille présentent des risques non négligeables d'obturation progressive dans le temps.

Le document dissuade par ailleurs d'utiliser, dans la paroi intermédiaire entre les deux chambres à pressions différentes, soit une ouverture de type transparente à la radiation EUV car cette ouverture n'empêcherait pas le passage des gaz vers la chambre aval de transmission, soit une fenêtre mince qui risquerait d'être endommagée par la haute température présente dans la zone d'irradiation.

Le document EP-0 858 249 décrit un dispositif de photolithographie pour semi-conducteurs destiné à minimiser la formation de débris en utilisant une source de rayons X issus d'un plasma qui est obtenu par irradiation d'un mélange de gaz et de particules par un laser. Le dispositif comporte une buse destinée à injecter un mélange de gaz et de particules dans une chambre maintenue à basse pression (10⁻² à 10⁻³ torr) par une pompe à vide, et une sortie pour l'évacuer. Le dispositif comporte aussi un générateur produisant un faisceau laser qui converge au moyen d'une lentille sur ce mélange pour produire un plasma émettant une radiation X de forte intensité. Le dispositif comporte enfin un miroir convergent pour diriger la radiation X vers un photomasque.

Le problème proposé par la présente invention est de concevoir une nouvelle source de radiation EUV, et un dispositif de photolithographie utilisant une telle source de radiation, permettant d'augmenter sensiblement l'intensité de la radiation EUV atteignant les couches à traiter pendant les procédés de photolithographie, afin que cette énergie soit suffisante pour une application industrielle dans la fabrication de composants de microélectronique.

L'invention vise également à éviter l'utilisation de dispositifs de transmission de radiation à canaux multiples, qui présentent les inconvénients précédemment mentionnés et qui s'opposeraient au passage d'une radiation laser incidente dans l'hypothèse où cette radiation proviendrait de la chambre de transmission aval.

Et l'invention vise à résoudre ces problèmes tout en utilisant des pompes à vide ayant des vitesses de pompage raisonnables, permettant d'utiliser des pompes peu volumineuses qui soient compatibles avec l'encombrement admissible des dispositifs de photolithographie de semi-conducteurs.

Pour atteindre ces buts ainsi que d'autres, l'invention propose une source de radiation dans l'Extrême UltraViolet (EUV) comprenant
- une chambre d'irradiation contenant une zone d'irradiation,
- une chambre de transmission séparée de la chambre d'irradiation par une paroi,
- des moyens pour injecter à l'entrée de la zone d'irradiation un flux de matériau générateur de radiation orienté selon une direction II-II transversale par rapport à un axe optique I-I,
- des moyens pour recueillir le flux de matériau générateur de radiation en sortie de la zone d'irradiation,
- des moyens pour générer et focaliser un rayonnement laser de puissance sur le matériau générateur de radiation dans la zone d'irradiation, et
- des moyens pour recueillir et conditionner la radiation EUV émise par le matériau générateur de radiation dans la zone d'irradiation, qui sont placés dans une chambre de transmission,
- des premiers moyens générateurs de vide connectés à une chambre d'irradiation dans laquelle est située la zone d'irradiation entretenant une première pression (P1),
la chambre de transmission (2) étant connectée à des seconds moyens générateurs de vide (12) entretenant une seconde pression P2 inférieure à la première pression P1, et communiquant avec la chambre d'irradiation(1) par un diaphragme (4) de dimension réduite ménagé dans la paroi (4a) à proximité immédiate de la zone d'irradiation (3) et orienté selon l'axe optique I-I, caractérisée en ce que les rayons laser de puissance (5, 6) incidents pénètrent dans la chambre d'irradiation (1) en traversant le diaphragme (4) et frappent le flux de matériau générateur de radiation sur la face du flux qui est orientée vers le diaphragme (4).

Selon un mode de réalisation avantageux, la seconde pression est inférieure ou égale au dixième de la première pression.

On pourra avantageusement choisir une première pression d'environ 5.10⁻³ millibars, et une seconde pression d'environ 5.10⁻⁴ millibars.

Le matériau générateur de radiation peut être du xénon gazeux, ou peut avantageusement être du xénon liquide.

En alternative, le matériau générateur de radiation peut être l'étain.

Le rayonnement laser de puissance atteint la zone d'irradiation sur sa face qui est en regard du diaphragme. A ce fin, on fait pénétrer des rayons laser de puissance dans la chambre d'irradiation depuis la chambre de transmission, en traversant le diaphragme.

Les moyens pour retenir et conditionner la radiation EUV peuvent avantageusement comprendre, en aval du diaphragme, un ou plusieurs miroirs elliptiques, orientés selon l'axe optique, et dont un foyer est situé dans la zone d'irradiation.

L'invention a encore pour objet un procédé de mise en oeuvre d'une source de radiation dans l'Extrême Ultra Violet (EUV) telle que précédemment décrite, dans lequel la pression P2 dans la chambre de transmission est inférieure à la pression P1 dans la chambre d'irradiation. De préférence la seconde pression P2 est inférieure ou égale au dixième de la première pression P1. Avantageusement la première pression P1 est inférieure, ou égale à 5.10⁻³ millibars, tandis que la seconde pression P2 est inférieure ou égale à 5.10⁻⁴ millibars.

On peut en outre avantageusement prévoir un dispositif anti-débris placé dans la chambre de transmission, en regard et à proximité du diaphragme, pour transmettre le rayonnement EUV aux moyens pour recueillir et conditionner la radiation EUV émise, tout en s'opposant au passage des ions et autres particules provenant de la chambre d'irradiation. Par exemple, le dispositif anti-débris peut comprendre un flux transversal d'hélium, d'argon ou de krypton, en aval du diaphragme, associé à des moyens pour recueillir le flux transversal d'hélium, d'argon ou de krypton, et les débris qu'il entraîne.

L'invention propose également un dispositif de photolithographie comprenant une source de radiation telle que définie ci-dessus pour générer une radiation EUV, un dispositif support de masque adapté pour supporter un masque, un support de plaquettes de semi-conducteur adapté pour supporter une plaquette de semi-conducteur à traiter, et un système optique adapté pour projeter sur la plaquette de semi-conducteur une image d'une portion du masque irradiée par la radiation EUV.

D'autres objets, caractéristiques et avantages de la présente invention ressortiront de la description suivante de modes de réalisation particuliers, faite en relation avec les figures jointes, parmi lesquelles :
- la figure 1 illustre schématiquement une structure générale de source EUV selon un mode de réalisation de la présente invention ;
- la figure 2 est une coupe longitudinale illustrant une réalisation pratique de la source EUV de la figure 1 ;
- la figure 3 est une vue à plus grande échelle montrant la zone d'irradiation de la figure 2 ;
- la figure 4 illustre une variante de réalisation pratique de source EUV selon l'invention ; et
- la figure 5 illustre l'application de la source EUV selon l'invention dans un dispositif de photolithographie.

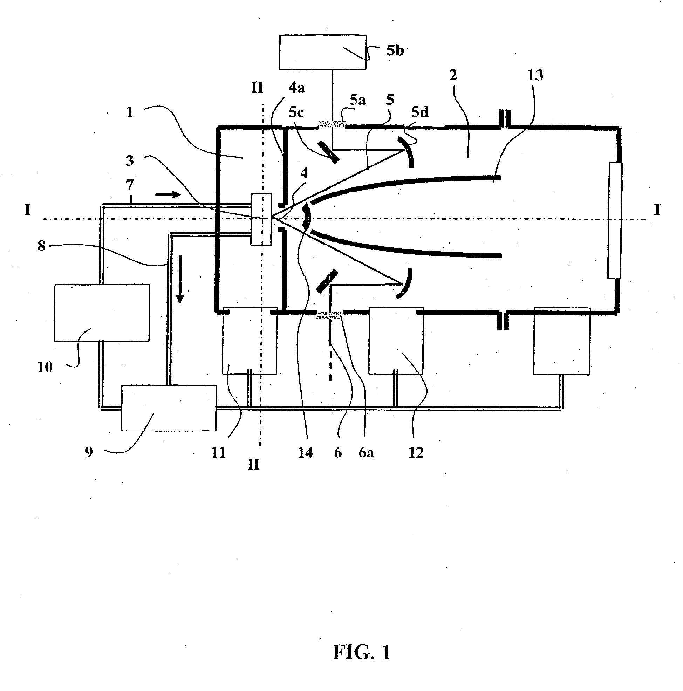

La figure 1 illustre schématiquement la structure générale d'une source EUV selon l'invention. On distingue une chambre d'irradiation 1, une chambre de transmission 2, une zone d'irradiation 3 située dans la chambre d'irradiation 1, un diaphragme 4 prévu dans une paroi intermédiaire 4a située entre la chambre d'irradiation 1 et la chambre de transmission 2. Le diaphragme 4 est orienté selon un axe optique I-I qui est l'axe général selon lequel on récupère les radiations EUV émises.

Des moyens d'injection 7 tels qu'une canalisation d'entrée, permettent d'injecter dans la zone d'irradiation 3 un flux de matériau générateur de radiation, qui se propage selon une direction II-II qui est transversale par rapport à l'axe optique I-I. Le flux de matériau générateur de radiation est récupéré en sortie de la zone d'irradiation 3 par une canalisation de recyclage 8 qui le retourne par une pompe primaire 9 vers un recycleur 10 le réinjectant ensuite dans la zone d'irradiation 3 par l'intermédiaire de la canalisation d'entrée 7.

Dans la zone d'irradiation 3, on fait arriver un rayonnement laser de puissance qui est constitué de préférence par une pluralité de rayons laser de puissance 5, 6, qui convergent vers la zone d'irradiation 3, et qui frappent le flux de matériau générateur de radiation pour produire une radiation EUV.

Les rayons laser frappent le flux de matériau générateur de radiation sur la face du flux qui est orientée vers le diaphragme 4, et on fait en sorte que le diaphragme 4 soit à proximité immédiate de la zone d'irradiation 3. De la sorte, la radiation EUV émise se propage préférentiellement à travers le diaphragme 4 vers la chambre de transmission 2, autour de l'axe optique I-I. Dans la chambre de transmission 2, des moyens tels qu'un dispositif collecteur 13 permettent de recueillir et de conditionner la radiation EUV émise par le matériau générateur de radiation dans la zone d'irradiation 3.

Le dispositif collecteur 13, situé dans la chambre de transmission 2, peut avantageusement comprendre un ou plusieurs miroirs elliptiques orientés selon l'axe optique I-I et ayant un premier foyer situé dans la zone d'irradiation 3. De la sorte, les miroirs elliptiques réfléchissent en majeure partie les rayons de radiation EUV pour les diriger vers le second foyer des miroirs elliptiques, second foyer que l'on place dans leur zone d'utilisation.

Un dispositif anti-débris 14 peut avantageusement être prévu dans la chambre de transmission 2 en regard et à proximité du diaphragme 4, pour transmettre le rayonnement EUV au dispositif collecteur 13 tout en s'opposant au passage des ions et autres particules depuis le diaphragme 4 vers le dispositif collecteur 13.

Un dispositif anti-débris 14 peut par exemple comprendre un flux transversal d'hélium, d'argon ou de krypton en aval du diaphragme 4.

Dans la zone d'irradiation 3, le matériau générateur de radiation peut par exemple être un flux de xénon gazeux, un flux de microgouttelettes liquides de xénon obtenues par pulvérisation, ou un spaguetto de xénon liquide.

En alternative, on peut envisager une cible en étain, qui a un meilleur rapport de conversion que le xénon, et peut ainsi générer une radiation EUV de plus forte intensité. La cible peut être un disque d'étain solide, ou un flux d'alliage d'étain liquide à température ambiante, tel qu'un alliage d'étain, d'indium et de plomb.

La chambre d'irradiation 1 est une chambre étanche, entourée d'une paroi étanche, et communiquant avec la chambre de transmission 2 par le seul diaphragme 4 qui est de dimension réduite, par exemple de l'ordre de 10 mm.

La chambre de transmission 2 est également une chambre étanche, entourée d'une paroi étanche et communiquant avec la chambre d'irradiation 1 par le seul diaphragme 4 de dimension réduite.

La chambre d'irradiation 1 est connectée à des premiers moyens générateurs de vide 11 qui entretiennent une première pression P1. Par exemple, comme illustré sur la figure 1, les premiers moyens générateurs de vide 11 peuvent comprendre une ou plusieurs premières pompes secondaires 11 turbomoléculaires dont l'aspiration est raccordée à la chambre d'irradiation 1 et dont le refoulement est raccordé à l'aspiration de la pompe primaire 9.

De même, la chambre de transmission 2 est connectée à des seconds moyens de génération de vide 12 qui entretiennent une seconde pression P2. Par exemple les seconds moyens de génération de vide 12 comprennent une ou plusieurs secondes pompes secondaires 12 turbomoléculaires dont l'aspiration est raccordée à la chambre de transmission 2 et dont le refoulement est raccordé à l'aspiration de la pompe primaire 9.

La seconde pression P2, présente dans la chambre de transmission 2, est inférieure à la première pression P1 présente dans la chambre d'irradiation 1, pour la raison expliquée ci-après.

Dans une telle source de radiation EUV par excitation laser d'un flux de matériau générateur de radiation, le matériau générateur de radiation, sous forme gazeuse ou liquide, tend à diffuser rapidement dans la chambre d'irradiation 1, et augmente ainsi la pression gazeuse régnant dans la chambre d'irradiation 1. Or une pression gazeuse élevée s'oppose rapidement à la propagation de la radiation EUV. Il faut donc entretenir, sur le trajet de propagation de la radiation EUV, un vide suffisamment poussé pour éviter l'absorption de la radiation utile. Mais l'entretien d'une pression basse, de l'ordre de 5 10⁻⁴ millibars, qui serait nécessaire pour permettre la propagation de la radiation EUV sur une longueur suffisante, nécessiterait de disposer de pompes assurant une vitesse de pompage effective très grande, par exemple supérieure à 30 000 litres par seconde. Or de telles pompes sont volumineuses, et ne peuvent pas être raisonnablement utilisées dans une source de radiation EUV pour procédé de photolithographie de semi-conducteurs.

Ainsi, on met à profit la présence de deux chambres distinctes, à savoir une chambre d'irradiation 1 et une chambre de transmission 2, pour entretenir un vide à deux pressions différentes.

Dans la chambre d'irradiation 1, on entretient un vide à une première pression P1 relativement élevée, et on s'arrange pour que la longueur du trajet suivi par les radiations EUV dans la chambre d'irradiation 1 soit très courte. Cela est réalisé grâce au fait que le diaphragme 4 est à proximité immédiate de la zone d'irradiation 3, et grâce au fait que le rayonnement laser de puissance frappe le flux de matériau générateur de radiation sur la face qui est en regard du diaphragme 4.

Par contre, la chambre de transmission 2 est maintenue à une pression P2 inférieure à la première pression P1 de la chambre d'irradiation 1. De la sorte, on réduit l'absorption de la radiation EUV utile dans son trajet traversant la chambre de transmission 2.

De préférence, la seconde pression P2 dans la chambre de transmission 2 est inférieure ou égale au dixième de la première pression P1 dans la chambre d'irradiation 1.

Par exemple, de bons résultats seront obtenus en prévoyant une première pression P1 inférieure ou égale à environ 5 10⁻³ millibars, et une seconde pression P2 inférieure ou égale à 5 10⁻⁴ millibars.

Le vide de 5 10⁻³ millibars peut être réalisé dans la chambre d'irradiation 1 par une ou deux premières pompes turbomoléculaires 11 assurant une vitesse totale de pompage de xénon d'environ 3 000 litres par seconde. La taille de la ou des premières pompes turbomoléculaires 11 est ainsi compatible avec l'encombrement admissible dans les installations de photolithographie pour fabrication de composants semi-conducteurs.

On constate que la présence d'un simple diaphragme 4, de dimension réduite, par exemple d'un diamètre de 10 millimètres environ, diminue très fortement le flux de matériau générateur de radiation qui se propage vers la chambre de transmission 2, selon un facteur d'environ 10. De la sorte, le vide plus poussé peut être réalisé et maintenu dans la chambre de transmission 2 par une ou deux secondes pompes turbomoléculaires 12 dont la vitesse totale de pompage de xénon est également d'environ 3 000 litres par seconde. La taille de la ou des secondes pompes turbomoléculaires 12 est ainsi réduit, et l'ensemble reste compatible avec l'encombrement acceptable dans les installations de photolithographie pour fabrication de semi-conducteurs.

Le simple diaphragme 4 présente l'avantage d'être multidirectionnel, c'est-à-dire d'admettre le passage de radiations pouvant être fortement obliques par rapport à l'axe optique I-I.

Il est alors possible de faire pénétrer les rayons laser de puissance 5 et 6 incidents dans la chambre d'irradiation 1 directement à travers le diaphragme 4, selon des directions obliques, comme cela est illustré sur la figure 1. Dans ce cas, les rayons lasers incidents 5 et 6 peuvent pénétrer dans la chambre de transmission 2 par des fenêtres 5a et 6a, en provenance de sources laser telles que la source 5b, ils peuvent être réfléchis par des miroirs tels que les miroirs 5c et 5d, pour se propager ensuite vers le diaphragme 4 à l'extérieur du dispositif collecteur 13, pour venir frapper la surface du flux de matériau générateur de radiation qui se trouve, dans la zone d'irradiation 3, à proximité immédiate du diaphragme 4.

En alternative, ne faisant pas partie de l'invention tel que revendiquée, on peut prévoir des rayons lasers incidents qui pénètrent directement dans la chambre d'irradiation 1 en amont du diaphragme 4, et qui se propagent vers la zone d'irradiation 3 le long de la paroi intermédiaire 4a, en amont du diaphragme 4. Dans ce cas, le diaphragme 4 est réalisé dans la paroi intermédiaire 4a qui peut avantageusement avoir une forme conique à sommet dirigé vers la zone d'irradiation 3.

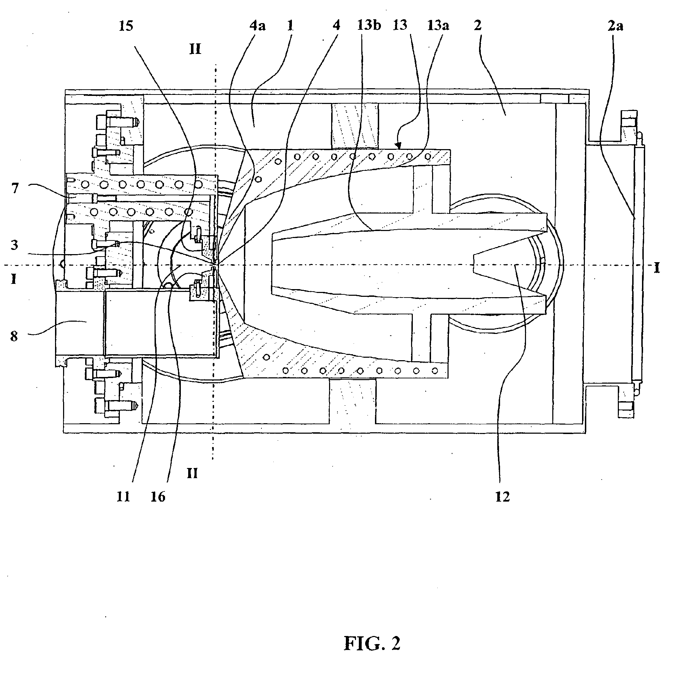

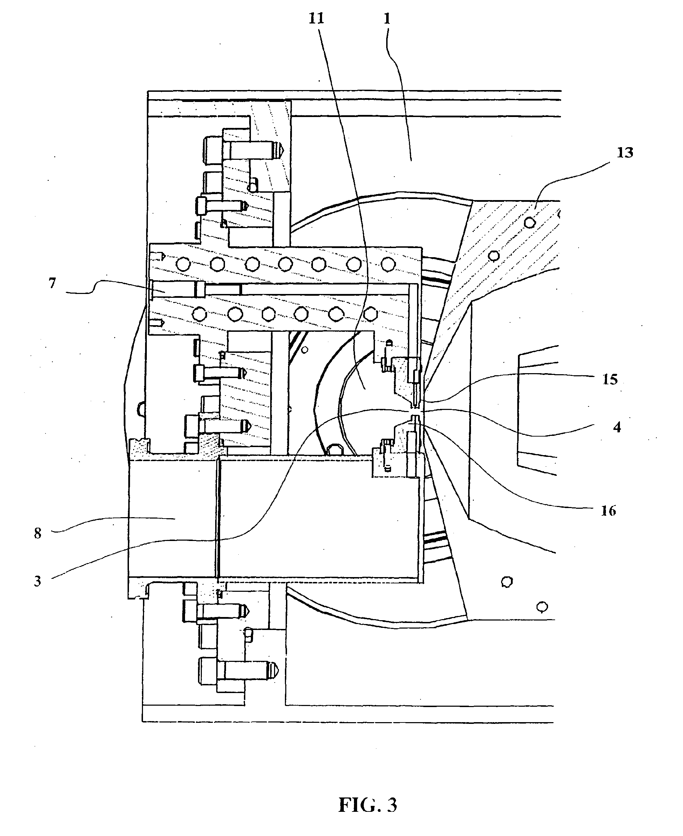

On considère maintenant les figures 2 et 3, qui illustrent en coupe longitudinale un premier mode de réalisation pratique d'une source EUV selon la présente invention.

On retrouve sur ces figures 2 et 3 les mêmes éléments que sur le schéma de principe de la figure 1, et ces éléments sont repérés par les mêmes références numériques.

Ainsi, on reconnaît la chambre d'irradiation 1 et la chambre de transmission 2 qui sont séparées par la paroi intermédiaire 4a munie du diaphragme 4. Une première pompe secondaire 11 est disposée latéralement, et on distingue son orifice d'aspiration communiquant directement avec la chambre d'irradiation 1. De même, une seconde pompe secondaire 12 est disposée latéralement, et on distingue son orifice d'aspiration communiquant directement avec la chambre de transmission 2.

Dans la chambre d'irradiation 1, la zone d'irradiation 3 est située entre un injecteur 15 relié à la canalisation d'entrée 7 et un écorceur 16 relié à la canalisation de recyclage 8. La canalisation d'entrée 7 et la canalisation de recyclage 8 sont coudées pour se raccorder respectivement à l'injecteur 15 et à l'écorceur 16, et elles pénètrent axialement dans la chambre d'irradiation 1. La zone d'irradiation est de courte longueur, par exemple de 3 mm environ.

Le dispositif collecteur 13 comprend par exemple deux miroirs elliptiques coaxiaux, à savoir un miroir elliptique extérieur 13a et un miroir elliptique intérieur 13b. Le miroir elliptique intérieur 13b est en retrait du diaphragme 4, comme illustré sur les figures, tandis que le miroir elliptique extérieur 13a se raccorde à une portion conique de la paroi intermédiaire 4a séparant la chambre d'irradiation 1 de la chambre de transmission 2. En alternative, le miroir elliptique extérieur 13a peut avantageusement se raccorder à un miroir hyperbolique entourant le diaphragme 4, de façon à optimiser la quantité de radiation EUV collectée.

Le dispositif collecteur 13 récupère la radiation EUV émise selon un angle solide centré sur l'axe optique I-I et défini sensiblement par un cône de 120° environ.

La chambre de transmission 2 est obturée en aval par une paroi 2a transparente à la radiation EUV émise, et éventuellement filtrante pour éliminer les radiations à longueur d'onde plus grande que la radiation désirée. La paroi 2a isole l'atmosphère régnant dans la chambre de transmission 2 de l'atmosphère régnant en aval de la paroi 2a.

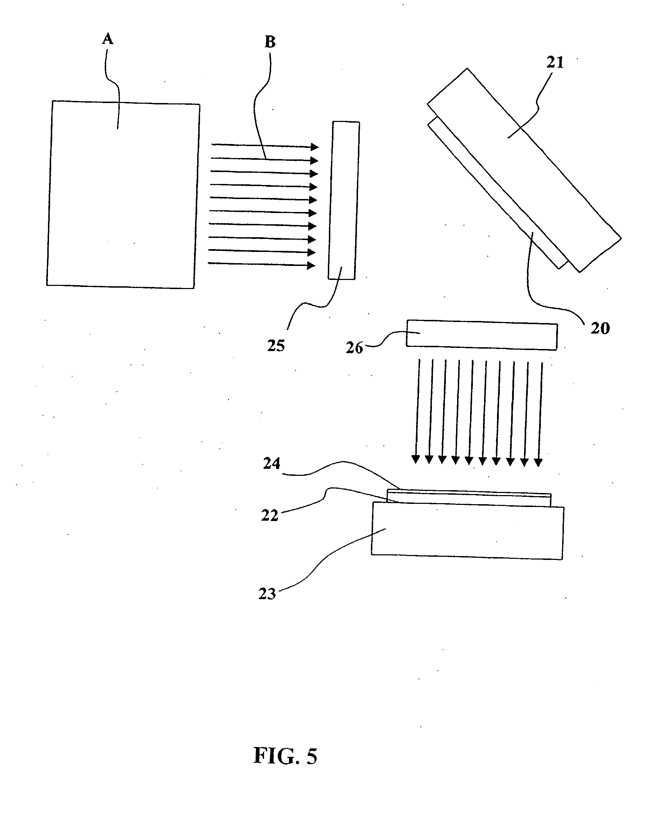

Les miroirs du dispositif collecteur 13 ont une forme elliptique, un premier foyer étant situé dans la zone de radiation 3, le second foyer étant situé à l'entrée 25 (figure 5) du système optique d'un répéteur de masque à réducteur optique 26, qui utilise la radiation pour traiter la plaquette de semi-conducteur. On focalise ainsi la radiation EUV à l'entrée 25 du système optique 25, 26.

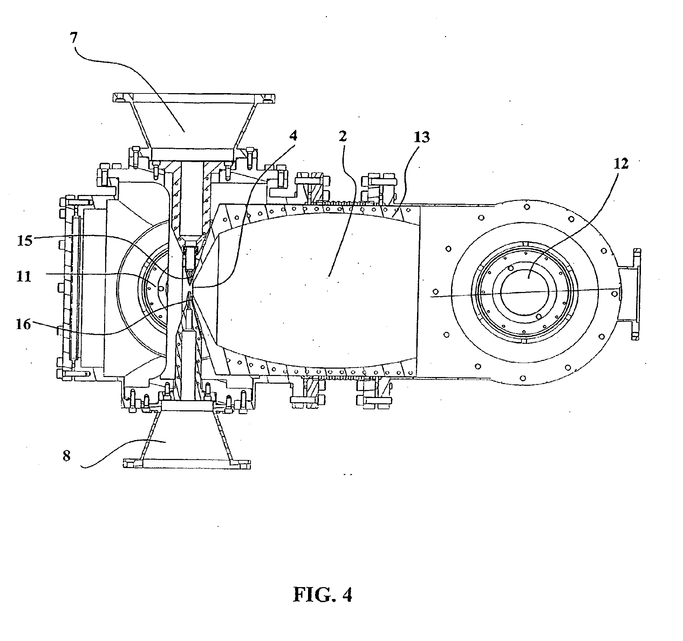

Sur la figure 4, on a représenté une variante de la source de radiation EUV de la figure 2, variante dans laquelle les canalisations 7 et 8 pénètrent radialement dans la chambre d'irradiation 1, en ligne avec respectivement l'injecteur 15 et l'écorceur 16.

La figure 5 illustre l'utilisation d'une source EUV selon l'invention pour le traitement d'une plaquette de semi-conducteur.

La source de radiation est illustrée globalement et repérée par la référence A. La radiation EUV B est dirigée, à travers l'entrée 25 du répéteur de masque, vers un masque 20 supporté par un dispositif support de masque 21. Le masque 20 est réfléchissant, et redirige la radiation, à travers le réducteur optique 26 du répéteur de masque, vers une plaquette de semi-conducteur 22 elle-même supportée par un support de plaquette 23. La plaquette de semi-conducteur 22 comporte par exemple une surface recouverte d'une couche 24 que l'on veut traiter par la radiation EUV, selon le motif du masque 20, avec un facteur de réduction déterminé par le réducteur optique 26.

La présente invention n'est pas limitée aux modes de réalisation qui ont été explicitement décrits, mais elle en inclut les diverses variantes et généralisations qui sont à la portée de l'homme du métier.

## Revendications

1. Source de radiation dans l'Extrême Ultra Violet (EUV) comprenant
- une chambre d'irradiation (1) contenant une zone d'irradiation (3),
- une chambre de transmission (2) séparée de la chambre d'irradiation par une paroi (4a),
- des moyens (7, 15) pour injecter à l'entrée de la zone d'irradiation (3) un flux de matériau générateur de radiation orienté selon une direction II-II transversale par rapport à un axe optique I-I,
- des moyens (8, 16) pour recueillir le flux de matériau générateur de radiation en sortie de la zone d'irradiation (3),
- des moyens pour générer et focaliser un rayonnement laser de puissance (5,6) sur le matériau générateur de radiation dans la zone d'irradiation (3), et
- des moyens (13) pour recueillir et conditionner la radiation EUV émise par le matériau générateur de radiation dans la zone d'irradiation (3), qui sont placés dans une chambre de transmission (2),
- des premiers moyens générateurs de vide (11) connectés à une chambre d'irradiation (1) dans laquelle est située la zone d'irradiation (3) entretenant une première pression (P1),
la chambre de transmission (2) étant connectée à des seconds moyens générateurs de vide (12) entretenant une seconde pression P2 inférieure à la première pression P1, et communiquant avec la chambre d'irradiation(1) par un diaphragme (4) de dimension réduite ménagé dans la paroi (4a) à proximité immédiate de la zone d'irradiation (3) et orienté selon l'axe optique I-I, **caractérisée en ce que** les rayons laser de puissance (5, 6) incidents pénètrent dans la chambre d'irradiation (1) en traversant le diaphragme (4) et frappent le flux de matériau générateur de radiation sur la face du flux qui est orientée vers le diaphragme (4).

2. Source de radiation selon la revendication 1, dans laquelle la seconde pression P2 est inférieure ou égale au dixième de la première pression P1.

3. Source de radiation selon l'une des revendications 1 ou 2, dans laquelle la première pression P1 est inférieure, ou égale à 5.10⁻³ millibars, tandis que la seconde pression P2 est inférieure ou égale à 5.10⁻⁴ millibars.

4. Source de radiation selon l'une des revendications 1 à 3, dans laquelle le matériau générateur de radiation est du xénon gazeux.

5. Source de radiation selon l'une des revendications 1 à 3, dans laquelle le matériau générateur de radiation est du xénon liquide.

6. Source de radiation selon l'une quelconque des revendications 1 à 3, **caractérisée en ce que** le matériau générateur de radiation est l'étain.

7. Source de radiation selon l'une des revendications précédentes, dans laquelle la chambre de transmission (2) comprend un ou plusieurs miroirs elliptiques (13a, 13b) orientés selon l'axe optique I-I et dont un foyer est situé dans la zone d'irradiation (3).

8. Source de radiation selon l'une des revendications précédentes comprenant en outre un dispositif anti-débris (14) prévu dans la chambre de transmission (2) en regard et à proximité du diaphragme (4), pour transmettre le, rayonnement EUV aux moyens (13) pour recueillir et conditionner la radiation EUV émise tout en s'opposant au passage des ions et autres particules provenant de la chambre d'irradiation (1).

9. Source de radiation selon la revendication 8, dans laquelle le dispositif anti-débris (14) comprend un flux transversal d'hélium, d'argon ou de krypton en aval du diaphragme (4).

10. Dispositif de photolithographie, comprenant une source de radiation EUV (A) pour générer une radiation EUV (B), un dispositif support de masque (21) adapté pour supporter un masque (20), un support de Plaquettes de semi-conducteur (23) adapté pour supporter une plaquette de semi-conducteur (22) à traiter, et un système optique (25, 26) adapté pour projeter sur la plaquette de semi-conducteur (22) une image d'une portion du masque (20) irradiée par la radiation EUV (B), dans laquelle la source de radiation (A) est une source selon l'une des revendications précédentes.

11. Dispositif de photolithographie selon la revendication 10, **caractérisé en ce que** la source de radiation (A) comprend des miroirs elliptiques dont un foyer est à l'entrée (25) du système optique (25, 26), pour focaliser la radiation EUV (B) à l'entrée (25) du système optique (25, 26).

12. Procédé de mise en oeuvre d'une source de radiation dans l'Extrême Ultra Violet (EUV) selon l'une des revendications 1 à 9, dans lequel la pression (P2) dans la chambre de transmission (2) est inférieure à la pression (P1) dans la chambre d'irradiation (1).

13. Procédé selon la revendication 12, dans lequel la seconde pression (P2) est inférieure ou égale au dixième de la première pression (P1).

14. Procédé selon l'une des revendications 12 et 13, dans lequel la première pression (P1) est inférieure, ou égale à 5.10⁻³ millibars, tandis que la seconde pression (P2) est inférieure ou égale à 5.10⁻⁴ millibars.

## Claims

1. Source of radiation in the Extreme Ultra Violet (EUV) comprising
- an irradiation chamber (1) containing an irradiation zone (3),
- a transmission chamber (2) separated from the irradiation chamber by a wall (4a),
- means (7, 15) for injecting, at the entry to the irradiation zone (3), a stream of radiation-generator material oriented along a transverse direction II-II in relation to an optical axis I-I,
- means (8, 16) for collecting the stream of radiation-generator material at the output of the irradiation zone (3),
- means for generating and focussing power laser radiation (5, 6) on the radiation-generator material in the irradiation zone (3), and
- means (13) for collecting and conditioning the EUV radiation emitted by the radiation-generator material in the irradiation zone (3), which are placed in a transmission chamber (2),
- first vacuum generator means (11) connected to an irradiation chamber (1) in which the irradiation zone (3) is located, maintaining a first pressure (P1),
the transmission chamber (2) being connected to second vacuum generator means (12), maintaining a second pressure P2 lower than the first pressure P1, and connecting to the irradiation chamber (1) through a diaphragm (4) with a reduced dimension housed in the wall (4a) in the immediate proximity of the irradiation zone (3) and oriented on the optical axis I-I, **characterized in that** the incident power laser beams (5, 6) penetrate the irradiation chamber (1) by passing through the diaphragm (4) and hit the stream of radiation-generator material on the face of the stream which is oriented towards the diaphragm (4).

2. Radiation source according to claim 1, in which the second pressure P2 is less than or equal to one tenth of the first pressure P1.

3. Radiation source according to one of claims 1 or 2, in which the first pressure P1 is less than or equal to 5.10⁻³ millibars, while the second pressure P2 is less than or equal to 5.10⁻⁴ millibars.

4. Radiation source according to one of claims 1 to 3, in which the radiation-generator material is gaseous xenon.

5. Radiation source according to one of claims 1 to 3, in which the radiation-generator material is liquid xenon.

6. Radiation source according to any of claims 1 to 3, **characterized in that** the radiation-generator material is tin.

7. Radiation source according to one of the previous claims, in which the transmission chamber (2) includes one or more elliptical mirrors (13a, 1,3b) oriented on the optical axis I-I and for which one focus is located in the irradiation zone (3).

8. Radiation source according to one of the previous claims, also including an anti-debris device (14) provided in the transmission chamber (2) facing and in the proximity of the diaphragm (4), to send the EUV radiation to the means (13) for collecting and conditioning the EUV radiation emitted while opposing the passing of ions and other particles coming from the irradiation chamber (1).

9. Radiation source according to claims 8, in which the anti-debris device (14) comprises a transverse stream of helium, argon or krypton downstream of the diaphragm (4).

10. Photolithography device, comprising a source of EUV radiation (A) for generating EUV radiation (B), a mask support device (21) adapted to support a mask (20), a semi-conductor wafer support (23) adapted to support a semi-conductor wafer (22) to be processed, and an optical system (25, 26) adapted to project onto the semi-conductor wafer (22) an image of a portion of the mask (20) irradiated by the EUV radiation (B), in which the radiation source (A) is a source according to one of the previous claims.

11. Photolithography device according to claim 10, **characterized in that** the radiation source (A) includes elliptical mirrors, one focus of which is at the entry (25) of the optical system (25, 26), to focus the EUV radiation (B) on the entry (25) to the optical system (25, 26).

12. Method for the implementation of a source of radiation in the Extreme Ultra Violet (EUV) according to one of claims 1 to 9, in which the pressure (P2) in the transmission chamber (2) is lower than the pressure (P1) in the irradiation chamber (1).

13. Method according to claim 12, in which the second pressure (P2) is lower than or equal to one tenth of the first pressure (P1).

14. Method according to one of claims 12 and 13, in which the first pressure (P1) is less than or equal to 5.10⁻³ millibars, while the second pressure (P2) is less than or equal to 5.10⁻⁴ millibars.

## Patentansprüche

1. Strahlungsquelle für extrem ultraviolette Strahlung (EUV), umfassend:
- Eine Bestrahlungskammer (1) mit einer Bestrahlungszone (3),
- eine Übertragungskammer (2), durch eine Wand (4a) von der Bestrahlungskammer getrennt (4a),
- Mittel (7, 15) zum Einspritzen, am Eingang der Bestrahlungszone (3), eines eine Strahlung erzeugenden Materialflusses, welcher gemäß einer Querrichtung II-II in Bezug auf eine optische Achse I-I ausgerichtet ist,
- Mittel zum (8, 16) Auffangen des die Strahlung erzeugenden Materialflusses am Ausgang der Bestrahlurigszone (3),
- Mittel zum Erzeugen und Fokussieren einer Leistungslaserstrahlung (5, 6) auf das eine Strahlung erzeugende Material in der Bestrahlungszone (3), und
- Mittel (13) zum Auffangen und Konditionieren der von dem eine Strahlung erzeugenden Material in der Bestrahlungszone (3) ausgegebenen EUV-Strahlung, welche in einer Übertragungskammer (2) angeordnet sind,
- erste Vakuumerzeugungsmittel (11), welche an eine Bestrahlungskammer (1), in welcher sich die Bestrahlungszone (3) befindet, angeschlossen sind und einen ersten Druck (P1) beibehalten,
wobei die Übertragungskammer (2) an zweite Vakuumerzeugungsmittel (12), welche einen zweiten Druck P2 beibehalten, der niedriger als der erste Druck P1 ist, angeschlossen ist und über eine Membran (4) mit reduzierter Abmessung, welche in der Wand (4a) in unmittelbarer Nähe der Bestrahlungszone (3) vorgesehen und gemäß der optischen Achse I-I ausgerichtet ist, mit der Bestrahlungskammer (1) verbunden ist, **dadurch gekennzeichnet, dass** die einfallenden Leistungslaserstrahlen (5, 6) durch die Membran (4) hindurch in die Bestrahlungskammer (1) eindringen und auf den eine Strahlung erzeugenden Materialfluss an der Seite, welche der Membran (4) zugewandt ist, aufschlagen.

2. Strahlungsquelle nach Anspruch 1, wobei der zweite Druck P2 niedriger als oder gleich ein Zehntel des ersten Druckes P1 ist.

3. Strahlungsquelle nach einem der Ansprüche 1 oder 2, wobei der erste Druck P1 niedriger als oder gleich 5,10⁻³ Millibar ist, während der zweite Druck P2 niedriger als oder gleich 5,10⁻⁴ Millibar ist.

4. Strahlungsquelle nach einem der Ansprüche 1 bis 3, wobei das die Strahlung erzeugende Material ein gasförmiges Xenon ist

5. Strahlungsquelle nach einem der Ansprüche 1 bis 3, wobei das die Strahlung erzeugende Material ein flüssiges Xenon ist.

6. Strahlungsquelle nach einem der Ansprüche 1 bis 3, **dadurch gekennzeichnet, dass** das die Strahlung erzeugende Material Zinn ist.

7. Strahlungsquelle nach einem der vorstehenden Ansprüche, wobei die Übertragungskammer (2) einen oder mehrere elliptische Spiegel (13a, 13b) umfasst, welche gemäß der optischen Achse I-I ausgerichtet sind, und von denen sich ein Brennpunkt in der Bestrahlungszone (3) befindet.

8. Strahlungsquelle nach einem der vorstehenden Ansprüche, weiterhin umfassend eine in der Übertragungskammer (2) vorgesehene, der Membran (4) zugewandte und in deren Nähe angeordnete Ftemdkärperfiltereinrichtung (14) für die Übertragung der EUV-Strahlung an die Mittel (13), um die ausgegebene EUV-Strahlung aufzufangen und zu konditionieren und gleichzeitig den Durchlass der von der Bestrahlungskammer (1) kommenden lone und sonstigen Partikel zu verhindern.

9. Strahlungsquelle nach Anspruch 8, wobei die Fremdkörperfiltereinrichtung (14) einen Querstrom von Helium, Argon oder Krypton hinter der Membran (4) umfasst.

10. Photolithographievorrichtung, umfassend eine EUV-Strahlungsquelle (A) zum Erzeugen einer EUV-Strahlung (B), eine Maskenträgereinrichtung (21) für die Aufnahme einer Maske (20), einen Halbleiterplatinenträger (23) für die Aufnahme einer zu bearbeitenden Halbleiterplatine (22), und ein optisches System (25, 26), welches für die Projektion eines Bildes eines von der EUV-Strahlung (B) bestrahlten Abschnitts der Maske (20) auf die Halbleiterplatine (22) ausgelegt ist, wobei die Strahlungsquelle (A) eine Quelle gemäß einem der vorstehenden Ansprüche ist.

11. Photolithographievorrichtung nach Anspruch 10, **dadurch gekennzeichnet, dass** die Strahlungsquelle (1) elliptische Spiegel umfasst, von denen sich ein Brennpunkt am Eingang (25) des optischen Systems (25, 26) befindet, um die EUV-Strahlung (B) am Eingang (25) des optischen Systems (25, 26) zu fokussieren.

12. Verfahren zur Anwendung einer Strahlungsquelle für extrem ultraviolette Strahlung (EUV) nach einem der Ansprüche 1 bis 9, wobei der Druck (P2) in der Übertragungskammer (2) niedriger als der Druck (P1) in der Bestrahlungskammer (1) ist.

13. Verfahren nach Anspruch 12, wobei der zweite Druck (P2) niedriger als oder gleich ein Zehntel des ersten Druckes (P1) ist.

14. Verfahren nach einem der Ansprüche 12 und 13, wobei der erste Druck (P1) niedriger als oder gleich 5,10⁻³ Millibar ist, während der zweite Druck (P2) niedriger als oder gleich 5.10⁻⁴ Millibar ist.
